# EUROPEAN PATENT SPECIFICATION

(11) **EP 2 829 888 B1**
(45) Date of publication and mention of the grant of the patent: **09.08.2017**
(21) Application number: 12877243.1
(22) Date of filing: 29.06.2012
(51) Int. Cl.: G01R 31/36, H04M 1/02, H01M 2/10, H01M 10/42, H01H 1/06, H01H 1/44, H01H 3/16

(54) **APPARATUS AND METHOD FOR IDENTIFYING BATTERIES OF DIFFERENT THICKNESSES, AND ELECTRONIC DEVICE**
VORRICHTUNG UND VERFAHREN ZUR IDENTIFIZIERUNG VON BATTERIEN VERSCHIEDENER DICKE UND ELEKTRONISCHE VORRICHTUNG
APPAREIL ET PROCÉDÉ PERMETTANT D'IDENTIFIER DES BATTERIES DE DIFFÉRENTES ÉPAISSEURS, ET DISPOSITIF ÉLECTRONIQUE

(30) Priority: 22.05.2012 CN 201210162828
(43) Date of publication of application: 28.01.2015
(73) Proprietor: ZTE Corporation, Shenzhen, Guangdong 518057 (CN)
(72) Inventor: MA, Kai, Shenzhen, Guangdong 518057 (CN); FANG, Jianmin, Shenzhen, Guangdong 518057 (CN)
(74) Representative: Schröer, Gernot H.
(86) International application number: PCT/CN2012/077846
(87) International publication number: WO 2013/174059

(56) References cited:
- WO-A1-03/028186
- CN-U- 201 689 162
- CN-Y- 2 842 367
- US-A1- 2004 033 718
- US-A1- 2005 026 035
- US-A1- 2012 094 154

## Description

### Technical Field

The present invention relates to the field of rechargeable battery technology used by electronic devices, and more particularly, to an apparatus and method for identifying batteries with different thicknesses, and an electronic device thereof.

### Background of the Invention

Currently, the market demands for portable electronic devices such as mobile terminals, laptops and tablet PCs that use rechargeable batteries as power source develop rapidly, and these electronic devices have more and more functions and applications, which results in more and more power consumption, and the devices' demand for battery capacity is growing. However, due to limitations of the existing battery technology, the battery capacity is often proportional to the battery volume. The power sustainability and portability of the devices are hard to co-exist, which results in that many electronic devices are equipped with two or even more sets of optional batteries, and in the same battery slot of the device, it needs to use batteries with different capacity and volume corresponding to the different needs. Such applications also bring in some problems, such as identifying batteries with different capacities, computing battery power, displaying the battery status, and so on.

Lithium batteries have advantages such as large storage capability, long life, lightweight, and no memory effect, and it has been widely used in existing portable devices. mAh is the measuring unit of battery capacity, specifically is the total number of electronics that can be released by the battery for external use, and it is equivalent to the physical standard unit: Coulomb. The international standard unit of Coulomb is ampere second which is obtained by multiplying current with time, 1mAh = 0.001 Ampere * 3600 seconds = 3.6 ampere seconds = 3.6 Coulomb.

In conventional electronic devices, there are the following three methods for calculating the battery power:
1. direct battery voltage monitoring method: the direct battery voltage monitoring method is simple and easy to implement; however, this method has low accuracy (20%), and it cannot effectively protect the battery;
2. battery modeling method: the battery modeling method effectively improves the power measurement accuracy (5%), it is easy to use and does not need to perform an initial estimate of the battery; however, the establishment of the data table is a complex process, and it has not good compatibility with batteries with different capacities or types;
3. coulometer detection method: the coulometer can accurately track the battery power change, and its accuracy can be up to 1%; however, the coulometer has the problem in initial estimate of the battery, it needs to know the rated capacity, the current capacity and present current loss, moreover, the precision of the current resistor directly affects the accuracy of battery power.

At present, the coulometer detection is the most accurate and effective method, and most of the popular smart mobile terminals, tablet computers and other electronic devices use coulometer detection method, however, the coulometer detection method can only solve problems of power computation and power display of batteries with a fixed capacity, while for batteries with different capacity, the coulometer detection method cannot calculate and display battery power accurately. Therefore, how to achieve a simple, fast and accurate identification of batteries with different capacities is currently a technical problem to be solved.

An apparatus for identifying batteries with different thicknesses is also known from US 2005/0026035 A1 and WO 03/028186 A1.

### Summary of the Invention

The purpose of the embodiments of the present invention is to provide an apparatus and method for identifying batteries with different thicknesses, and an electronic device thereof, to identify whether a thin battery or a thick battery is used in said electronic device, and further use different drivers to manage said battery.

The embodiments of the present invention provide the apparatus for identifying batteries with different thicknesses according to claim 1, the method for identifying batteries with different thicknesses according to claim 7 and the electronic device according to claim 11.

Said apparatus for identifying batteries with different thicknesses in accordance with an embodiment of the present invention comprises a buckle switch arranged at a position close to a battery compartment in an electronic device and a control circuit connected with said buckle switch;
said buckle switch being configured to: when a thin battery is mounted in said electronic device, said buckle switch's state is ON; when a thick battery is mounted in said electronic device, the state is OFF;
said control circuit being configured to: according to the state of ON/OFF of said buckle switch, identify whether a thin battery or a thick battery is mounted in said electronic device.

Alternatively, said buckle switch comprises a buckle, a spring member and a switch device, and said buckle is configured to be inserted into a housing of said electronic device by slotting, an arc-shaped contact surface is provided on one side of said battery compartment that is close to said buckle, and a slot is provided on the other side; said spring member is connected to said slot and said switch device respectively;
said buckle switch is configured as:
   when a battery is loaded into said battery compartment, said battery contacting with said arc-shaped contact surface on one side of said buckle, and squeezing said spring member on the other side of said buckle; wherein, when the thick battery is loaded into said battery compartment, said buckle is pressed down, and said spring member is squeezed to trigger said slot to press said switch device down; when the thin battery is loaded into said battery compartment, said buckle is not pressed down, and a force of said spring member drives said switch device to pop up.

Said control circuit comprises a baseband processing chip, and said buckle switch is connected with a general purpose input output (GPIO) port of said baseband processing chip, and said baseband processing chip is configured to determine the state of said buckle switch being ON or OFF according to a level state of said GPIO port.

Alternatively, a number of said buckles and said spring members is one or more.

Alternatively, said control circuit is further configured to, after identifying the battery mounted in said electronic device, respectively call appropriate power management modules to calculate and/or display power of said electronic device's power supply.

Alternatively, said switch device comprises: a mechanical press-contact switch, a flexible printed circuit (FPC) switch, or a stylus switch.

Alternatively, said switch device is configured as:
being welded on said motherboard;
alternatively, an elastic pin on said switch device being pressed to touch a metal contact point of said motherboard;
alternatively, a metal contact point of said switch device being pressed and touched by an elastic pin set on said motherboard.

Furthermore, the method for identifying batteries with different thicknesses in accordance with an embodiment of the present invention comprises:
arranging a buckle switch connected with a control circuit at a position close to a battery compartment in an electronic device;
when a thin battery is mounted in said electronic device, a state of said buckle switch being ON; when a thick battery is mounted in said electronic device, the state of said buckle switch being OFF;
according to the state of ON/OFF of said buckle switch, said control circuit identifying whether a thin battery or a thick battery is mounted in said electronic device.

Said control circuit comprises a baseband processing chip, and said buckle switch is connected with a GPIO port of said baseband processing chip, and said baseband processing chip determines the state of said buckle switch being ON or OFF according to a level state of said GPIO port.

Alternatively, said buckle switch comprises a buckle, a spring member and a switch device, and said buckle is fitted in a housing of said electronic device by slotting, one side of the buckle that is close to said battery compartment is provided with an arc-shaped contact surface, and the other side is provided with a slot; said spring member is respectively connected with said slot and said switch device;
when said battery is loaded into said battery compartment, said battery contacts with said arc-shaped contact surface on one side of said buckle, and squeezes said spring member on the other side of said buckle;
wherein, when the thick battery is loaded into said battery compartment, said buckle is pressed down, said spring member is squeezed and triggers said slot to press said switch device down; when a thin battery is loaded into said battery compartment, said buckle is not pressed down, and a force of said spring member drives said switch device to pop up.

Alternatively, said switch device is welded on said motherboard;
alternatively, a metal contact point is disposed on said motherboard, and an elastic pin on said switch device is pressed to touch said metal contact point;
alternatively, an elastic pin is set on said motherboard, and said elastic pin is pressed to touch a metal contact point of said switch device.

Alternatively, the method further comprises:
after said control circuit identifies the battery mounted in said electronic device, respectively calling appropriate power management modules to calculate and/or display power of said electronic device's power supply.

The embodiment of the present invention further provides an electronic device, comprising the abovementioned apparatus.

Compared with the prior art, the embodiments of the present invention have at least the following advantages:
1. simply and accurately judging the battery type, having a low cost, having a relatively simple implementation, and it is simple, easy to implement;
2. reducing the cost, structural members (comprising rear housing, battery cover, and so on) do not need to change when using thick and thin two batteries, and they can share one set of structural members;
3. the buckle switch can play the function of fixing the battery, when using a battery with different thickness, the battery does not shift, thus the whole user experience is good;
4. the type of battery can be automatically identified and managed without the user separately processing and selecting a program, thus the user experience is good.

### Brief Description of the Drawings

The accompanying drawings described herein are used to provide a further understanding of the embodiments of the present invention, and constitute a part of the present application, exemplary embodiments of the present invention and their description are used to explain the present invention and do not constitute an unduly limit of the present invention. In the accompanying drawings:
- FIG. 1a and FIG. 1b: are respectively schematic diagrams of mounting batteries with two different thicknesses in an electronic device;
- FIG. 2: is a schematic diagram of a control circuit of a buckle switch in accordance with an embodiment of present invention;
- FIG. 3: is an exploded view of a mobile terminal with a buckle switch in accordance with an embodiment of the present invention;
- FIG. 4: is a schematic diagram of a buckle switch in accordance with an embodiment of the present invention;
- FIG. 5a and FIG. 5b: are respectively schematic diagrams of internal assemblies of a mobile terminal with a buckle switch in accordance with an embodiment of the present invention;
- FIG. 6a and FIG. 6b: are respectively schematic diagrams of battery assemblies of a mobile terminal with a buckle switch in accordance with an embodiment of the present invention.

### Preferred Embodiments of the Present Invention

The present embodiment provides an apparatus and method for identifying batteries with different thicknesses, specifically using the following scheme:
said apparatus comprising a buckle switch and a control circuit;
when a thin battery is mounted in said electronic device, the state of said buckle switch is ON; when a thick battery is mounted in said electronic device, the state of said buckle switch is OFF;
said control circuit identifies whether a thin battery or a thick battery is mounted in said electronic device according to the state of said buckle switch.

Wherein, said buckle switch comprises a buckle, a spring member and a switch device, one side of said buckle is provided with an arc-shaped contact surface in contact with the side surface of a battery body, and the other side is provided with a slot with a spring member; said spring member is respectively connected with said slot and said switch device.

Preferably, the mechanical part of said buckle switch consists of one or more buckles whose upper surface is arc and lower surface is planar (the side of said buckle has a slot with said spring member), a spring member, and a switch device connected to a motherboard, and said switch device may be a mechanical switch or a FPC (flexible printed circuit) switch.

Preferably, said buckle switch works as a single-pole double-throw switch in circuit connection and has two states, ON and OFF, wherein the state of ON is a state pulled high by the high level, and the state of OFF is a grounding state. The ON/OFF state of said buckle switch is determined by the relative positions of said battery and said buckle switch, the state information of said buckle switch is fed back to said baseband processing chip via said GPIO bus. After said baseband processing chip obtains the information of said state, it calls corresponding battery information to manage power management modules and manages said battery according to different states. When a thin battery is mounted in said terminal device, after the installation, said buckle is bounced up, and the state of said buckle switch is ON. When a thick battery is mounted in said terminal apparatus, the buckle is pressed down after the installation, and the state of said buckle switch is OFF.

When said battery is placed into said battery compartment from the top of said motherboard, one end of said battery contacts on the upper surface of said buckle, forces the arc-shaped surface retracted from the side into a side slot of said battery. When the battery thickness is small, through the thickness journey, the side buckle is no longer subject to force and pops out, the switch state is OFF; when the battery is relatively thick, through the thickness journey, the side buckle is forced in the still thick battery journey, thus will not pop out, and the switch state is ON.

Preferably, the switch device connecting to said motherboard have many forms, which can be a mechanically pressed touch switch, a FPC switch, a stylus switch, and so on. The connection methods can be different according to different switch forms. It can be that the switch is directly soldered on said motherboard; a metal contact point is set on said motherboard, an elastic pin on said switch is pressed to touch said contact point; or an elastic pin is set on said motherboard, and said elastic pin is pressed to touch said metal contact point on said switch.

Hereinafter with reference to the accompanying drawings, the embodiments of the present invention will be described in detail. It should be noted that, in the case of no conflict, the embodiments and features in the embodiments of the present application may be arbitrarily combined with each other.

In the following embodiments, the mobile terminal is taken as an example to describe a specific implementation of the present invention, but the invention scheme is not limited to be applied to mobile terminals, it can be similarly applied to other electronic devices such as laptops and tablet PCs.

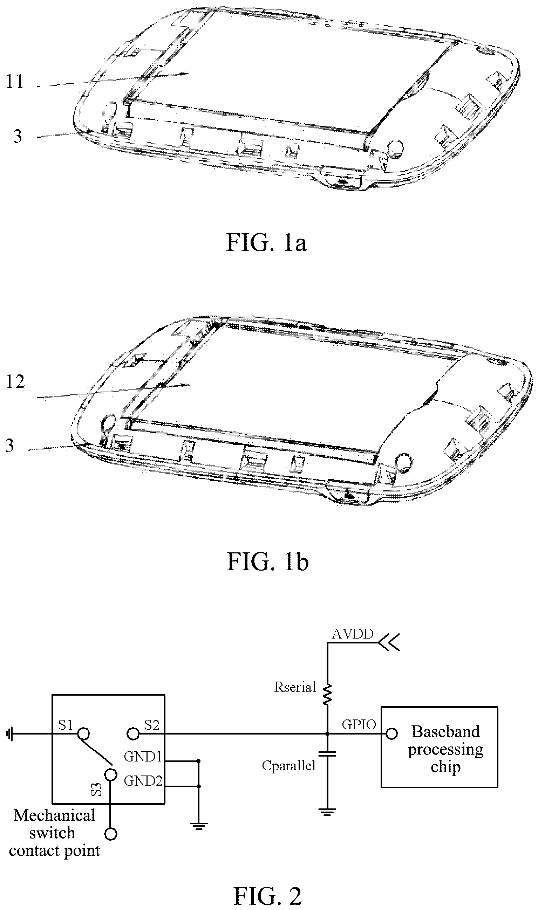

As shown in FIG. 1a and FIG. 1b, the mobile terminal is taken as an example to describe the schematic diagrams of the batteries with different thicknesses: thin battery 11 and thick battery 12 being respectively assembled in the rear housing 3 of the same electronic device.

FIG. 2 shows a schematic diagram of a control circuit of a buckle switch in accordance with an embodiment of the present invention. As shown in FIG. 2, the basic working principle of the mechanical switch is: within the mechanical switch, it contains three working pins S1, S2 and S3, under normal circumstances, pin S1 is directly used to connect to the ground, and the definition of pins S2 and S3 is determined according to practical applications.

There are two switching states in accordance with the embodiment of the present invention:
state 1: S1 is in the state of being shorted to ground, S2 is still floating and connected to a GPIO port via a pull-up resistor network, S3 is a mechanical switch contact point, when said S3 is not triggered, the switch is in the state that said S1 is disconnected with S2;
state 2: S1 is in the state of being shorted to ground; when said S3 is triggered, it connects the pin S2 with the pin S1 of the switch; when triggered by said S3, said S2 changes from the floating state to the state of connecting with said S1, and is in the grounding state; said switch is in the state that said S1 and said S2 are touching.

Said control circuit only needs one state (high or low state) to make said baseband processing chip control the state of peripherals and achieve the corresponding functions. Under normal circumstances, a analog voltage AVDD (value is 2.8V) commonly used in the mobile phone is used at said GPIO (General Purpose Input Output) port, and a resistor Rserial is connected to the GPIO port in series to perform said pull-up processing method, meanwhile, a parallel capacitor Cparallel is set aside for filtering out some interference signals.

When the mechanical switch is in state 1, since said S2 is still floating, it is equivalent to an infinite ohm resistor in the circuit, and said equivalent infinite resistor and said Rserial consist in a resistor divider network, the voltage at the GPIO port and the AVDD voltage are the same, at this time said GPIO is a high level.

When said mechanical switch is in state 2, since said S2 is in the grounding state, it is equivalent to a zero ohm resistor in the circuit, when said zero ohm resistor and said Rserial consist into a resistor divider network, the voltage at said GPIO port is zero, at this time said GPIO is a low level.

The two states: high and low levels of said GPIO port respectively correspond to thick and thin two types of batteries, thus by judging the high or low level at the GPIO port on said baseband processing chip, the thick and thin type of said battery can be determined, thus achieving different power controls.

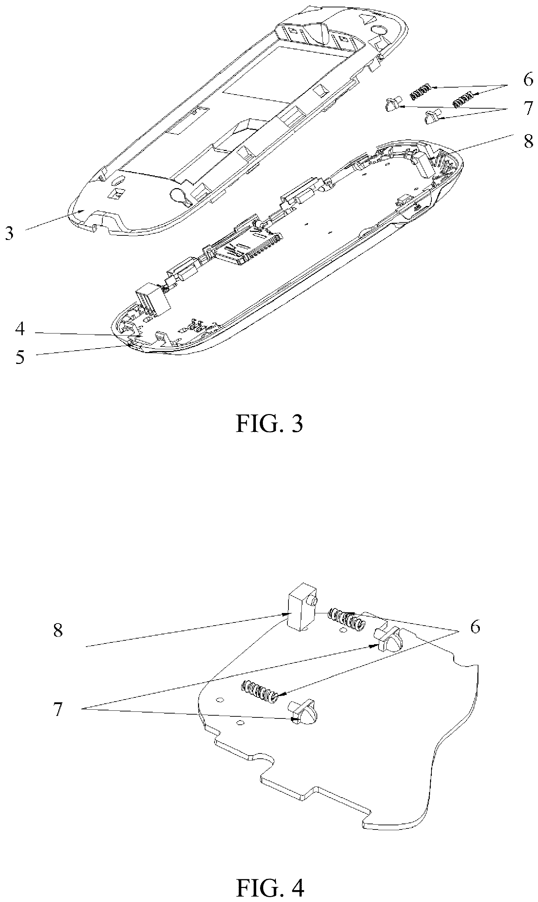

FIG. 3 shows an exploded diagram of an identification device with a buckle switch by taking the mobile terminal as an example, and said mobile terminal comprises motherboard 4, front housing 5 and rear housing 3, wherein, a buckle switch component is provided on said motherboard 4. There are two slots provided in the rear housing 3, and the buckle 7 of said buckle switch component is embedded in the rear housing 3 by slotting, and partially exposed on the surface, the upper arc-shaped surface of said buckle 7 is upward, the side of said buckle has a cylinder, in which spring 6 can be inserted, said spring 6 is connected to the switch device 8 connected on said motherboard (the method for said switch device 8 connecting with said motherboard can be soldering, screw fixing, or a combination of various methods).

When said buckle 7 is forced, it presses said spring 6 from the side, the cylinder of said buckle forces said switch device 8 to be pressed down; when said buckle 7 is not forced any longer, said spring 6 rebounds said buckle 7 outwardly, and said switching device 8 is not forced any longer and bounced up. Both in the thick and thin battery assemblies, the arc-shaped surface of said buckle 7 will be pressed to force it retracted inwardly.

FIG. 4 shows a schematic diagram of a buckle switch in accordance with an embodiment of the present invention. FIG. 4 takes two buckles for example, one buckle is connected with said switch device on said motherboard to play the roles of detecting said switch and fixing said battery, and the other one is connected with structural members to fix said battery. There is one cylinder at the side of said buckle, when the arc-shaped surface of the buckle receives a force, said cylinder presses said spring inwardly and presses said switch device, and said switch device changes from state 1 to state 2. When said battery is loaded and the device is powered on, said baseband processing chip detects the state of said switch device, if it is in said state 1, said baseband processing chip calls thin battery status information and manages said battery, if it is in said state 2, said baseband processing chip calls thick battery status information and manages said battery.

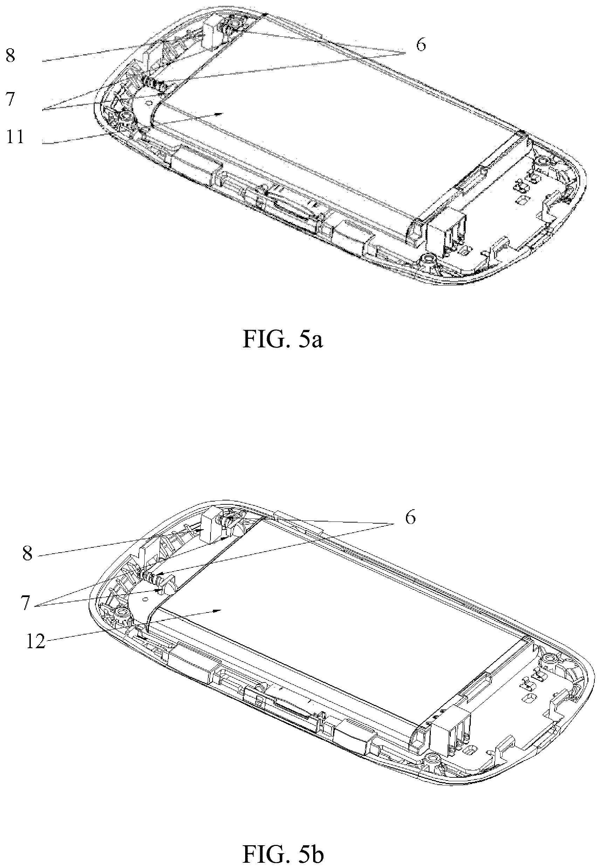

FIG. 5 shows an assembly diagram of assembling thick and thin batteries in an identification device with a buckle switch, the height of thin battery 12 is small, when said switch device 8 is no longer forced after the journey of the height of said thin battery, said buckle 7 buckles thin battery 12 so it does not fall out, said spring 6 rebounds said buckle 7 out, said switch device 8 is not forced to press down. The highness of said thick battery 11 is relatively large, said buckle 7 is keeping forced after the thick battery is buckled; said buckle 7 presses said spring 6 and presses said switch device 8 down, and said switch device 8 is pressed down by the force, and its state changes. In addition, FIG. 5 takes two buckles for example, one is connected with a switch device on the motherboard to fix said battery and detect said switch, and the other one is connected with a structural member to fix said battery.

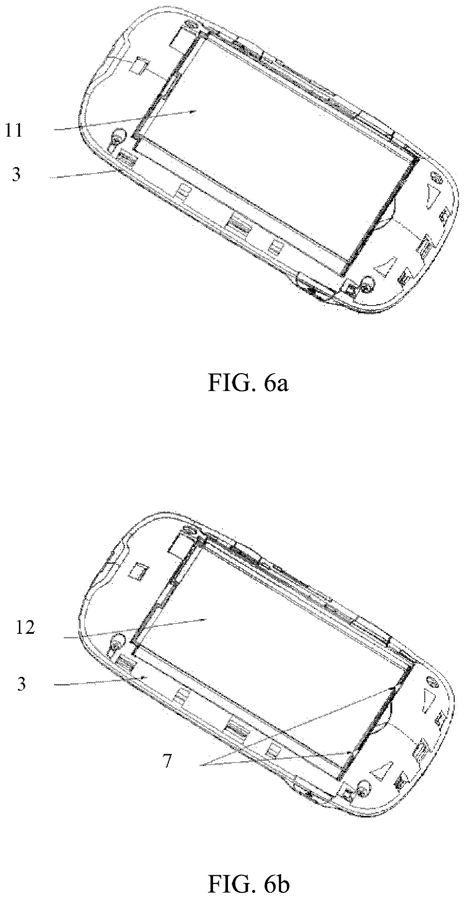

FIG. 6 is a schematic diagram of an assembly of a mobile terminal battery with a buckle switch identification device. Take a mobile terminal with two buckles for example, it can be seen that when the thin battery 12 is assembled, said buckle 7 first retracts and then pops out and buckles with said thin battery 12 after the assembly, at this time, the state of said switch is state 1; when the thick battery 11 is assembled, the buckle 7 retracts, and after the assembly, said buckle 7 does not pop up, at this time, the state of said switch is state 2.

In summary, the embodiments of the present invention combine the simple control circuit with the buckle switch to provide a structure that can accurately judge the thick and thin batteries, at the same time of being responsible for identification, said switch can also be used as a buckle structure to fix the thin battery, and a set of structural members can be used to batteries with different thicknesses; meanwhile, the corresponding battery information can be called to manage said batteries. The embodiment of the present invention is advantageous in that it has a simple structure and low cost, and can accurately judge the thick and thin batteries in the electronic devices.

The above description is only preferred embodiments of the present invention and not intended to limit the present invention, and the present invention may also have a variety of other embodiments, without departing from the essence of the present invention, a person skilled in the art may make various corresponding changes and modifications based on the embodiments of the present invention, and these changes and modifications fall within the protection scope of the appended claims of the present invention.

Obviously, those skilled in the art should understand that, each abovementioned module or step of the present invention can be achieved with a general-purpose computing device, and they can be integrated on a single computing device or distributed in a network composed of a plurality of computing devices, alternatively, they may be implemented with program codes executable by a computing device, so that they can be stored in a storage means and executed by a computing device, moreover in some cases, the steps shown or described herein may be processed in a order different from what is shown here, or they are made into separate integrated circuit modules, or some of the modules or steps can be made into a single integrated circuit module to implement. Thus, the present invention is not limited to any specific combination of hardware and software.

### Industrial Applicability

The apparatus in accordance with the embodiments of the present invention have a simple structure and low cost, and can accurately identify thick and thin batteries in electronic devices.

## Claims

1. An apparatus for identifying batteries (11,12) with different thicknesses, comprising a buckle switch arranged at a position close to a battery compartment in an electronic device and a control circuit connected with said buckle switch; wherein
said buckle switch is configured such that : when a thin battery (11) is mounted in said electronic device, said buckle switch's state is ON; when a thick battery (12) is mounted in said electronic device, the state is OFF; said control circuit is configured to: according to the state of ON/OFF of said buckle switch, identify whether a thin battery (11) or a thick battery (12) is mounted in said electronic device; **characterised in that** said control circuit comprises a baseband processing chip, and said buckle switch is connected with a general purpose input output, GPIO, port of said baseband processing chip, and said baseband processing chip is configured to determine the state of ON/OFF of said buckle switch according to a level state of said GPIO port, so as to use different drivers to manage said battery.

2. The apparatus of claim 1, wherein,
said buckle switch comprises a buckle (7), a spring member (6) and a switch device (8), and said buckle (7) is configured to be inserted into a housing of said electronic device by slotting, an arc-shaped contact surface is provided on one side of said battery compartment that is close to said buckle (7), and a slot is provided on the other side; said spring member (6) is connected to said slot and said switch device (8) respectively;
said buckle switch is configured such that:
when a battery is loaded into said battery compartment, said battery contacts said arc-shaped contact surface on the one side of said buckle (7), and squeezes said spring member (6) on the other side of said buckle (7); wherein, when the thick battery is loaded into said battery compartment, said buckle (7) is pressed down, and said spring member (6) is squeezed to trigger said slot to press said switch device (8) down; when the thin battery is loaded into said battery compartment, said buckle (7) is not pressed down, and a force of said spring member (6) drives said switch device (8) to pop up.

3. The apparatus of claim 1 or 2, wherein,
a number of said buckles (7) and said spring members (6) is one or more.

4. The apparatus of claim 1, 2 or 3, wherein,
said control circuit is further configured to, after identifying the battery mounted in said electronic device, respectively call appropriate power management modules to calculate and/or display power of said electronic device's power supply.

5. The apparatus of claim 2, wherein,
said switch device (8) comprises: a mechanical press-contact switch, a flexible printed circuit, FPC, switch, or a stylus switch.

6. The apparatus of claim 2, wherein, said switch device (8) is configured as:
being welded on a motherboard (4);
alternatively, an elastic pin on said switch device (8) being pressed to touch a metal contact point of said motherboard (4);
alternatively, a metal contact point of said switch device (8) being pressed and touched by an elastic pin set on said motherboard (4).

7. A method for identifying batteries (11,12) with different thicknesses, comprising:
arranging a buckle switch connected with a control circuit at a position close to a battery compartment in an electronic device;
when a thin battery (11) is mounted in said electronic device, a state of said buckle switch being ON; when a thick battery (12) is mounted in said electronic device, the state of said buckle switch being OFF;
according to the state of ON/OFF of said buckle switch, said control circuit identifying whether a thin battery (11) or a thick battery (12) is mounted in said electronic device; **characterised in that** the method further comprises:
said control circuit comprising a baseband processing chip, and said buckle switch being connected with a GPIO port of said baseband processing chip, and said baseband processing chip determining the state of said buckle switch being ON or OFF according to a level state of said GPIO port so as to use different drivers to manage said battery.

8. The method of claim 7, wherein,
said buckle switch comprises a buckle (7), a spring member (6) and a switch device (8), and said buckle (7) is fitted in a housing of said electronic device by slotting, one side of the buckle (7) that is close to said battery compartment is provided with an arc-shaped contact surface, and the other side is provided with a slot; said spring member (6) is respectively connected with said slot and said switch device (8);
when said battery is loaded into said battery compartment, said battery contacts with said arc-shaped contact surface on one side of said buckle (7), and squeezes said spring member (6) on the other side of said buckle (7);
wherein, when the thick battery is loaded into said battery compartment, said buckle (7) is pressed down, said spring member (6) is squeezed and triggers said slot to press said switch device (8) down; when a thin battery is loaded into said battery compartment, said buckle (7) is not pressed down, and a force of said spring member (6) drives said switch device (8) to pop up.

9. The method of claim 8, wherein,
said switch device (8) is welded on a motherboard (4);
alternatively, a metal contact point is disposed on said motherboard (4), and an elastic pin on said switch device (8) is pressed to touch said metal contact point;
alternatively, an elastic pin is set on said motherboard (4), and said elastic pin is pressed to touch a metal contact point of said switch device (8).

10. The method of claim 7 or 8, further comprising:
after said control circuit identifies the battery mounted in said electronic device, respectively calling appropriate power management modules to calculate and/or display power of said electronic device's power supply.

11. An electronic device, comprising the apparatus in any one of claims 1-6.

## Patentansprüche

1. Einrichtung zum Identifizieren von Batterien (11, 12) mit verschiedenen Dicken, die einen Verschluss-Schalter, der an einer Position in der Nähe eines Batteriefachs in einer elektronischen Vorrichtung angeordnet ist, und eine Steuerschaltung umfasst, die mit dem Verschluss-Schalter verbunden ist;
wobei
der Verschluss-Schalter derart konfiguriert ist, dass:
der Zustand des Verschluss-Schalters dann, wenn eine dünne Batterie (11) in der elektronischen Vorrichtung montiert ist, "EIN" ist;
der Zustand des Verschluss-Schalters dann, wenn eine dicke Batterie (12) in der elektronischen Vorrichtung montiert ist, "AUS" ist;
die Steuerschaltung konfiguriert ist:
entsprechend dem Ein- bzw. Aus-Zustand des Verschluss-Schalters zu identifizieren, ob eine dünne Batterie (11) oder eine dicke Batterie (12) in der elektronischen Vorrichtung montiert ist;
**dadurch gekennzeichnet, dass** die Steuerschaltung einen Grundbandverarbeitungschip umfasst, der Verschluss-Schalter mit einem Mehrzweck-Eingang-Ausgang-Anschluss (GPIO-Anschluss) des Grundbandverarbeitungschips verbunden ist und der Grundbandverarbeitungschip konfiguriert ist, den EIN/AUS-Zustand des Verschluss-Schalters entsprechend einem Pegelzustand des GPIO-Anschlusses zu bestimmen, um verschiedene Treiber zu verwenden, um die Batterie zu verwalten.

2. Einrichtung nach Anspruch 1, wobei
der Verschluss-Schalter einen Verschluss (7), ein Federorgan (6) und eine Schaltvorrichtung umfasst, und der Verschluss (7) zum Einführen in ein Gehäuse der elektronischen Vorrichtung durch Einstecken ausgebildet ist, wobei auf einer Seite des Batteriefachs, die sich in der Nähe des Verschlusses (7) befindet, eine bogenförmige Kontaktfläche vorgesehen ist und auf der anderen Seite ein Schlitz vorgesehen ist; wobei das Federorgan (6) mit dem Schlitz bzw. der Schaltvorrichtung (8) verbunden ist:
der Verschluss-Schalter derart konfiguriert ist, dass:
dann, wenn eine Batterie in das Batteriefach geladen wird, diese Batterie die bogenförmige Kontaktfläche auf der einen Seite des Verschlusses (7) kontaktiert und das Federorgan (6) auf der anderen Seite des Verschlusses (7) zusammendrückt; wobei der Verschluss (7) dann, wenn die dicke Batterie in das Batteriefach geladen wird, heruntergedrückt wird und das Federorgan (6) zusammengedrückt wird, um den Schlitz zu veranlassen, die Schaltvorrichtung (8) nach unten zu drücken; wobei der Verschluss (7) dann, wenn die dünne Batterie in das Batteriefach geladen wird, nicht nach unten gedrückt wird und eine Kraft des Federorgans (6) die Schaltvorrichtung (8) antreibt, auszuklappen.

3. Einrichtung nach Anspruch 1 oder 2, wobei eine Anzahl der Verschlüsse (7) und der Federorgane (6) eins oder mehr beträgt.

4. Einrichtung nach Anspruch 1, 2 oder 3, wobei die Steuerschaltung ferner konfiguriert ist, nach dem Identifizieren der Batterien, die in der elektronischen Vorrichtung montiert worden sind, jeweils geeignete Leistungsverwaltungsmodule aufzurufen, um die Leistung der Leistungsversorgung der elektronischen Vorrichtung zu berechnen und/oder anzuzeigen.

5. Einrichtung nach Anspruch 2, wobei die Schaltvorrichtung (8) Folgendes umfasst: einen mechanischen Druckkontaktschalter, einen Schalter einer flexiblen gedruckten Schaltung (FPC-Schalter) oder einen Tastschalter.

6. Vorrichtung nach Anspruch 2, wobei die Schaltvorrichtung (8) konfiguriert ist:
auf eine Hauptplatine (4) geschweißt zu sein ;
alternativ als ein elastischer Stift auf der Schaltvorrichtung (8), der gedrückt wird, um einen Metallkontaktpunkt auf der Hauptplatine (4) zu berühren;
alternativ als ein Metallkontaktpunkt der Schaltvorrichtung (8), der von einem elastischen Stiftsatz auf der Hauptplatine (4) gedrückt und berührt wird.

7. Verfahren zum Identifizieren von Batterien (11, 12) mit verschiedenen Dicken, das Folgendes umfasst:
Anordnen eines Verschluss-Schalters, der mit einer Steuerschaltung verbunden ist, an einer Position in der Nähe eines Batteriefachs in einer elektronischen Vorrichtung;
wobei ein Zustand des Verschluss-Schalters dann, wenn eine dünne Batterie (11) in der elektronischen Vorrichtung montiert ist, "EIN" ist;
wobei ein Zustand des Verschluss-Schalters dann, wenn eine dicke Batterie (12) in der elektronischen Vorrichtung montiert ist, "AUS" ist;
Identifizieren durch die Steuerschaltung, ob eine dünne Batterie (11) oder eine dicke Batterie (12) in der elektronischen Vorrichtung montiert ist, entsprechend dem EIN/AUS-Zustand des Verschluss-Schalters;
**dadurch gekennzeichnet, dass** das Verfahren ferner Folgendes umfasst:
die Steuerschaltung, die einen Grundbandverarbeitungschip umfasst, und den Verschluss-Schalter, der mit einem GPIO-Anschluss des Grundbandverarbeitungschips verbunden ist, und den Grundbandverarbeitungschip, der den Zustand des Verschluss-Schalters entsprechend einem Pegelzustand des GPIO-Anschlusses als "EIN" oder "AUS" identifiziert, um verschiedene Treiber zu verwenden, um die Batterie zu verwalten.

8. Verfahren nach Anspruch 7, wobei der Verschluss-Schalter einen Verschluss (7), ein Feder-Organ (6) und eine Schaltvorrichtung (8) umfasst und der Verschluss (7) durch Einstecken in ein Gehäuse der elektrischen Vorrichtung eingebaut ist, eine nah zum Batteriefach befindliche Seite des Verschlusses (7) mit einer bogenförmigen Kontaktfläche versehen ist, und die andere Seite mit einem Schlitz versehen ist, wobei das Federorgan (6) mit dem Schlitz bzw. der Schaltvorrichtung (8) verbunden ist;
wobei die Batterie dann, wenn eine Batterie in das Batteriefach geladen wird, die bogenförmige Kontaktfläche auf der einen Seite des Verschlusses (7) kontaktiert, und das Federorgan (6) auf der anderen Seite des Verschlusses (7) zusammendrückt;
wobei der Verschluss (7) dann, wenn die dicke Batterie in das Batteriefach geladen wird, heruntergedrückt wird, das Federorgan (6) zusammengedrückt wird und das Federorgan (6) den Schlitz veranlasst, die Schaltvorrichtung (8) nach unten zu drücken; wobei der Verschluss (7) dann, wenn eine dünne Batterie in das Batteriefach geladen wird, nicht nach unten gedrückt wird und eine Kraft des Federorgans (6) die Schaltvorrichtung (8) antreibt, auszuklappen.

9. Verfahren nach Anspruch 8, wobei
die Schaltvorrichtung (8) auf eine Hauptplatine (4) geschweißt ist;
alternativ ein Metallkontaktpunkt auf der Hauptplatine (4) angeordnet ist und ein elastischer Stift auf der Schaltvorrichtung (8) gedrückt wird, um den Metallkontaktpunkt zu berühren;
alternativ ein elastischer Stift auf die Hauptplatine (4) gesetzt wird und der elastische Stift gedrückt wird, um einen Metallkontaktpunkt auf der Schaltvorrichtung (8) zu berühren.

10. Verfahren nach Anspruch 7 oder 8, das ferner Folgendes umfasst:
nachdem die Steuerschaltung die Batterie, die in der elektronischen Vorrichtung montiert worden ist, identifiziert, jeweils Aufrufen der geeigneten Leistungsverwaltungsmodule, um die Leistung der Leistungsversorgung der elektronischen Vorrichtung zu berechnen und/oder anzuzeigen.

11. Elektronische Vorrichtung, die die Einrichtung nach einem der Ansprüche 1-6 umfasst.

## Revendications

1. Appareil pour identifier des batteries (11, 12) avec différentes épaisseurs, comprenant un commutateur à boucle agencé à une position proche d'un compartiment de batterie dans un dispositif électronique et un circuit de commande connecté au dit commutateur à boucle ; dans lequel
ledit commutateur à boucle est configuré de sorte que : lorsqu'une batterie mince (11) est montée dans ledit dispositif électronique, ledit état du commutateur à boucle est l'état activé ; lorsqu'une batterie épaisse (12) est montée dans ledit dispositif électronique, l'état est l'état désactivé ;
ledit circuit de commande est configuré pour : conformément à l'état activé/désactivé dudit commutateur à boucle, identifier si une batterie mince ou une batterie épaisse (12) est montée dans ledit dispositif électronique ;
**caractérisé en ce que** ledit circuit de commande comprend une puce de traitement de bande de base, et ledit commutateur à boucle est connecté à un port GPIO, General Purpose Input Output, de ladite puce de traitement de bande de base, et ladite puce de traitement de bande de base est configurée pour déterminer l'état activé/désactivé dudit commutateur à boucle conformément à un état de niveau dudit port GPIO, de manière à utiliser différents pilotes pour gérer ladite batterie.

2. Appareil selon la revendication 1, dans lequel
ledit commutateur à boucle comprend une boucle (7), un élément de ressort (6) et un dispositif de commutation (8), ladite boucle (7) est configurée pour être insérée par enfichage dans un logement dudit dispositif électronique, une surface de contact en forme d'arc est prévue d'un côté dudit compartiment de batterie qui est à proximité de ladite boucle (7), et un élément d'insertion est prévu de l'autre côté ; ledit élément de ressort (6) est relié au dit élément d'insertion et au dit dispositif de commutation (8), respectivement ;
ledit commutateur à boucle est configuré de sorte que :
lorsqu'une batterie est chargée dans ledit compartiment de batterie, ladite batterie vienne en contact avec ladite surface de contact en forme d'arc dudit un côté de ladite boucle (7), et comprime ledit élément de ressort (6) de l'autre côté de ladite boucle (7) ; dans lequel, lorsque la batterie épaisse est chargée dans ledit compartiment de batterie, ladite boucle (7) est pressée, et ledit élément de ressort (6) est comprimé de manière à déplacer ledit élément d'insertion pour presser ledit dispositif de commutation (8) ; lorsque la batterie mince est chargée dans ledit compartiment de batterie, ladite boucle (7) n'est pas pressée, et une force dudit élément de ressort (6) amène ledit dispositif de commutation (8) à sortir.

3. Appareil selon la revendication 1 ou 2, dans lequel
les nombres desdites boucles (7) et desdits éléments de ressort (6) sont égaux à un ou plus.

4. Appareil selon la revendication 1, 2 ou 3, dans lequel
ledit circuit de commande est en outre configuré pour, après l'identification de la batterie montée dans ledit dispositif électronique, appeler respectivement des modules de gestion de puissance appropriés pour calculer et/ou afficher la puissance de ladite alimentation du dispositif électronique.

5. Appareil selon la revendication 2, dans lequel
ledit dispositif de commutation (8) comprend : un commutateur à contact à pression mécanique, un circuit imprimé souple, FPC, un commutateur, ou un commutateur de stylet.

6. Appareil selon la revendication 2, dans lequel ledit dispositif de commutation (8) est configuré de sorte :
qu'il soit soudé sur une carte-mère (4) ;
en variante, qu'une broche élastique sur ledit dispositif de commutation (8) soit pressée pour toucher un point de contact métallique de ladite carte-mère (4) ;
en variante, qu'un point de contact métallique dudit dispositif de commutation (8) soit pressé et touché par une broche élastique fixée sur ladite carte-mère (4).

7. Procédé pour identifier des batteries (11, 12) avec différentes épaisseurs, comprenant :
l'agencement d'un commutateur à boucle connecté à un circuit de commande à une position proche d'un compartiment de batterie dans un dispositif électronique ;
lorsqu'une batterie mince (11) est montée dans ledit dispositif électronique, un état dudit commutateur à boucle est l'état activé ; lorsqu'une batterie épaisse (12) est montée dans ledit dispositif électronique, l'état dudit commutateur à boucle est l'état désactivé ;
conformément à l'état activé/désactivé dudit commutateur à boucle, ledit circuit de commande identifie si une batterie mince (11) ou une batterie épaisse (12) est montée dans ledit dispositif électronique ; **caractérisé en ce que** le procédé consiste en outre **en ce que** :
ledit circuit de commande comprend une puce de traitement de bande de base, et ledit commutateur à boucle est connecté à un port GPIO de ladite puce de traitement de bande de base, et ladite puce de traitement de bande de base détermine que l'état dudit commutateur à boucle est l'état activé ou l'état désactivé conformément à un état de niveau dudit port GPIO de manière à utiliser différents pilotes pour gérer ladite batterie.

8. Procédé selon la revendication 7, dans lequel
ledit commutateur à boucle comprend une boucle (7), un élément de ressort (6) et un dispositif de commutation (8), et ladite boucle (7) est insérée dans un logement dudit dispositif électronique d'insertion, un côté de la boucle (7) qui est proche dudit compartiment de batterie est pourvu d'une surface de contact en forme d'arc, et l'autre côté est pourvu d'un élément d'insertion ; ledit élément de ressort (6) est relié respectivement à l'élément d'insertion et au dit dispositif de commutation (8) ;
lorsque ladite batterie est chargée dans ledit compartiment de batterie, ladite batterie vient en contact avec ladite surface de contact en forme d'arc d'un côté de ladite boucle (7), et comprime ledit élément de ressort (6) de l'autre côté de ladite boucle (7) ;
dans lequel, lorsque la batterie épaisse est chargée dans ledit compartiment de batterie, ladite boucle (7) est pressée, ledit élément de ressort (6) est comprimé et déplace ledit élément d'insertion de manière à presser ledit dispositif de commutation (8) ; lorsqu'une batterie mince est chargée dans ledit compartiment de batterie, ladite boucle (7) n'est pas pressée, et une force dudit élément de ressort (6) amène ledit dispositif de commutation (8) à sortir.

9. Procédé selon la revendication 8, dans lequel
ledit dispositif de commutation (8) est soudé sur une carte-mère (4) ;
en variante, un point de contact métallique est disposé sur ladite carte-mère (4), et une broche élastique sur ledit dispositif de commutation (8) est pressée de manière à toucher ledit point de contact métallique ;
en variante, une broche élastique est fixée sur ladite carte-mère (4), et ladite broche élastique est pressée de manière à toucher un point de contact métallique dudit dispositif de commutation (8).

10. Procédé selon la revendication 7 ou 8, comprenant en outre :
après que ledit circuit de commande a identifié la batterie montée dans ledit dispositif électronique, l'appel respectivement de modules de gestion de puissance appropriés pour calculer et/ou afficher la puissance de ladite alimentation du dispositif électronique.

11. Dispositif électronique, comprenant l'appareil selon l'une quelconque des revendications 1 à 6.
